# EUROPÄISCHE PATENTSCHRIFT

(11) **EP 0 361 285 B1**
(45) Veröffentlichungstag und Bekanntmachung des Hinweises auf die Patenterteilung: **31.08.1994**
(21) Anmeldenummer: 89117325.4
(22) Anmeldetag: 19.09.1989
(51) Int. Cl.: H03K 17/98, H01H 13/70

(54) **Kapazitive Schaltungskarte**
Capacitive circuit board
Carte à circuit capacitif

(30) Priorität: 30.09.1988 DE 8812393 U; 27.01.1989 DE 8900946 U
(43) Veröffentlichungstag der Anmeldung: 04.04.1990
(73) Patentinhaber: Siemens Nixdorf Informationssysteme Aktiengesellschaft, 33102 Paderborn (DE)
(72) Erfinder: Acher, Gottfried, Ing. grad., D-8901 Königsbrunn (DE)
(74) Vertreter: Fuchs, Franz-Josef, Dr.-Ing.

(56) Entgegenhaltungen:
- DE-A- 2 434 390
- FR-A- 2 059 273
- GB-A- 2 090 979
- US-A- 3 797 630

## Beschreibung

Die Erfindung betrifft eine kapazitive Schaltungskarte gemäß dem Oberbegriff des Patentanspruchs 1. Eine solche Schaltungskarte ist aus der Offenlegungsschrift DE-A-24 34 390 bekannt.

Solche kapazitiven Schaltungskarten werden in zunehmendem Maße in neu konzipierten Tastaturen der professionellen DV-Technik eingesetzt, um die Zuverlässigkeit der Tastaturen zu verbessern und zugleich ihre Herstellungskosten zu reduzieren.

Aus der europäischen Patentanmeldung mit der Veröffentlichungsnummer EP-A-O 305 931 ist z.B. eine Tastaturvorrichtung bekannt, bei der eine Tastenplatte zusammen mit einem Rahmenelement und einem Auflageteil als einstückiges Formteil ausgebildet ist, und bei der unmittelbar an der Unterseite der Tastenplatte eine kapazitive Schaltungskarte befestigt ist.

Gegenüber herkömmlichen Tastaturen, deren Tasten auf Schaltelemente einwirken, die über je einen galvanischen Kontakt eine Zeilen- und eine Spaltenleitung in einer Tastenmatrix miteinander verbinden, werden bei Tastaturen mit kapazitiven Schaltelementen die Zeilen- und Spaltenleitungen nicht galvanisch miteinander verbunden.

Aus diesem Grund werden auch keine Entkopplungsglieder, wie z.B. jeweilige, den galvanischen Kontakten in Serie geschaltete Dioden benötigt.

Ein kapazitives Schaltelement kann auf einfache Weise durch zwei auf einer Leiterkarte zu Kondensatorflächen ausgebildeten Leiterflächen realisiert sein, die an eine jeweilige Zeilen- bzw. Spaltenleitung der Tastenmatrix angeschlossen sind. Durch Betätigen einer Taste wird lediglich eine Veränderung der Kapazität eines betreffenden kapazitiven Schaltelementes herbeigeführt. Dies kann entweder durch Annähern eines Dielektrikumelementes geschehen oder auch durch Verringern des Abstandes zwischen den Kondensatorflächen, ebenso wie durch Vergrößern einer der Kondensatorflächen.

Mit Hilfe einer an sämtliche Zeilen- und Spaltenleitungen angeschlossenen Auswerteelektronik kann eine Kapazitätsveränderung zwischen den Zeilen- und Spaltenleitungen erkannt, und eine betätigte Taste anhand der beteiligten Leitungen identifiziert werden.

Funktionsausfälle auf Grund von oxidierten oder deformierten galvanischen Kontakten sowie defekten Entkopplungsgliedern können daher bei Tastaturen mit kapazitiven Schaltelementen nicht auftreten.

Da sich die kapazitiven Schaltelemente lediglich aus einzelnen Leiterflächen zusammensetzen und die Leiterflächen über Zeilen- und Spaltenleitungen in der Regel miteinander verbunden sind, ist es im Sinne einer Kostenreduzierung naheliegend gewesen, für sämtliche kapazitiven Schaltelemente einer Tastatur eine gemeinsame Leiterplatte vorzusehen, auf der sich kein sonstiges elektronisches Bauteil befindet. Im Regelfall ist eine solche Leiterplatte als flexible Leiterfolie ausgebildet und wird dann als kapazitive Schaltfolie bezeichnet.

Für solche in verschiedensten Ausführungen erhältlichen kapazitiven Schaltfolien ist eine aufwendige Auswerteelektronik erforderlich, da sich in der Regel bei Betätigung eines kapazitiven Schaltelementes nur eine sehr geringe Kapazitätsveränderung einstellt. Durch parasitäre Koppelkapazitäten, die sich durch parallel geführte Leiterbahnen und eng nebeneinander liegende kapazitive Schaltelemente bilden können, wird die beim Betätigen einer Taste zu erkennende Kapazitätsveränderung zudem noch verringert.

Aufgabe der vorliegenden Erfindung ist es daher, eine kapazitive Schaltungskarte der eingangs genannten Art so zu verbessern, daß der Einfluß parasitärer Koppelkapazitäten reduziert wird.

Gelöst wird die Aufgabe erfindungsgemäß durch die im kennzeichnenden Teil des Patentanspruchs 1 angegebenen Merkmale.

Vorteilhafte Weiterbildungen der Erfindung ergeben sich aus den abhängigen Ansprüchen.

Mit einer erfindungsgemäß ausgestalteten kapazitiven Schaltungskarte läßt sich der Aufwand für eine Auswerteelektronik gering halten. Die Gründe dafür werden erst deutlich unter der Annahme, daß die Leiterbahnenflächen der ersten Schirmungsfläche in ihrer Gesamtheit gesehen im Vergleich zu der von den zweiten Schirmungsflächen überdeckten Fläche vernachlässigbar sind. Denn dann ist sichergestellt, daß zwei beliebige Leitungen (Zeilen-Spaltenleitungen) der kapazitiven Schaltungskarte, zwischen denen unter Umständen eine parasitäre Koppelkapazität existiert, keine Koppelkapazitäten zur ersten Schirmungsfläche, wohl aber eine zu den zweiten Schirmungsflächen aufweisen.

Im Prinzip sind Koppelkapazitäten mit Schirmungsflächen erwünscht, damit elektrische Störladungen, die durch parasitäre Koppelkapazitäten von einer störenden Leitung auf eine gestörte Leitung eingekoppelt werden, an ein Spannungspotential, in der Regel das Massepotential abfließen können. Bei der erfindungsgemäßen kapazitiven Schaltungskarte ist dies möglich, weil die zweiten Schirmungsflächen mit der ersten Schirmungsfläche elektrisch verbunden sind und diese an ein Spannungspotential (Massepotential) angeschlossen ist.

Da nun aber sowohl die störende als auch die gestörte Leitung über je eine Koppelkapazität mit dem Spannunspotential verbunden sind, sind diese beiden Koppelkapazitäten im Prinzip in Serie geschaltet und damit parallel an die parasitäre Koppelkapazität angeschlossen. Nachteilig ist, daß dadurch die parasitäre Koppelkapazität noch vergrößert wird, und elektrische Störladungen vermehrt auf eine gestörte Leitung überfließen können.

Im Idealfall sollten elektrische Störladungen über die Koppelkapazität an die Schirmungsfläche und dann möglichst ungehindert an ein Spannungspotential (Massepotential) abfließen. Elektrische Störladungen sollten aber daran gehindert werden, über die Koppelkapazitäten und eine Schirmungsfläche von einer auf eine andere Leitung, z.B. von einer Zeilenleitung auf eine Spaltenleitung zu fließen.

Bei der erfindungsgemäßen Schaltungskarte wird dies nun damit erzielt, daß die zweiten Schirmungsflächen gegenüber der ersten Schirmungsfläche eine geringere elektrische Leitfähigkeit aufweisen. Elektrische Störladungen, die über eine Koppelkapazität auf die zweiten Schirmungsflächen gelangen, müssen einen gewissen, von der elektrischen Leitfähigkeit der zweiten Schirmungsfläche abhängigen Widerstand überwinden (z.B. 10 Ohm bei Grafit) bis sie auf eine Leiterbahn der ersten Schirmungsfläche treffen, in der sie dann ohne Hindernisse (sehr gute Leitfähigkeit, z.B. 1 Ohm bei Silber) an das Spannungspotential abfliessen können. Um wieder über eine Koppelkapazität auf eine Leitung zurückzugelangen, müßten die elektrischen Störladungen dann nocheinmal den Widerstand der zweiten Schirmungsflächen überwinden, weshalb sich mit der erfindungsgemäßen Schaltungskarte die Anzahl der über die Schirmungsflächen auf eine Leitung gelangenden Störladungen gering halten läßt, als dies bei Schaltungskarten möglich ist, die nur eine aus einer einzigen geschlossenen Fläche bestehende Schirmungsfläche aufweisen.

Die Leitermaterialien Silber und Grafit sind galvanisch problemlos miteinander zu kombinieren und eignen sich auch gut, um im Siebdruckverfahren aufgebracht zu werden. Um die meist dünnen Leiterbahnen des Leiterbahnengitters zu schützen, ist es von Vorteil, die zweiten Leiterflächen als geschlossene Fläche auszubilden und damit das Leiterbahnengitter als Ganzes zu überdecken. Zudem wird damit der Aufwand für das Aufbringen der zweiten Schirmungsflächen im Siebdruckverfahren verringert.

Anhand der Zeichnung wird im folgenden ein Ausführungsbeispiel der Erfindung näher erläutert.

Dabei zeigen
FIG 1 einen prinzipiellen Aufbau einer kapazitiven Schaltungskarte im perspektivischen Querschnitt,
FIG 2 ein Schaltbild zur Darstellung kapazitiver Zusammenhänge.

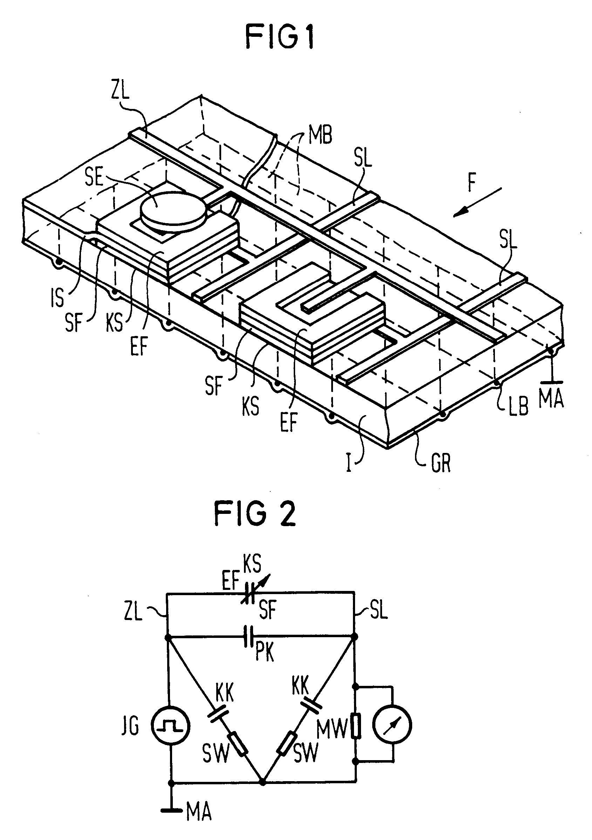

Die FIG 1 zeigt in schematischer Darstellung ein Teilstück einer kapazitiven Schaltungskarte F. In perspektivischer Seitenansicht sind zwei kapazitive Schaltelemente KS dargestellt, die nebeneinander auf einer gemeinsamen Trägerschicht I angeordnet sind. Diese kapazitiven Schaltelemente KS bestehen jeweils aus zwei parallel übereinander liegenden, durch eine Isolierschicht IS voneinander getrennten und damit zu Kondensatorflächen ausgebildeten Leiterflächen, nämlich einer Erregerfläche EF und einer Sensorfläche SF. Die Sensorflächen SF der kapazitiven Schaltelemente KS sind an jeweils eine Spaltenleitung SL einer Tastenmatrix (nicht dargestellt) angeschlossen. Die Erregerflächen EF sind im unbetätigten Zustand einer jeweils zugehörigen Taste ohne jegliche galvanische Verbindung. Erst bei Betätigen einer Taste wird ein ihr zugehöriges Kontaktelement SE auf die jeweilige Erregerfläche EF und eine ihr zugehörige Zeilenleitung ZL abgesenkt, wobei eine galvanische Verbindung zwischen der Erregerfläche EF und der Zeilenleitung ZL hergestellt wird.

An der den kapazitiven Schaltelementen KS gegenüberliegenden Oberfläche der Trägerschicht I haftet ein Leiterbahnengitter (gestrichelt dargestellt), dessen Maschenbereiche MB jeweils etwa eine Fläche von einem Quadratzentimeter aufweisen. Die Leiterbahnen LB des Leiterbahnengitters sind etwa 0,3mm breit.

Abgedeckt ist das gesamte Leiterbahnengitter mit einer geschlossenen Schicht aus Grafit GR.

In FIG 2 ist ein Schaltbild dargestellt, bei dem das elektrische Zusammenwirken der einzelnen Koppelkapazitäten auf der erfindungsgemäßen kapazitiven Schaltungskarte ersichtlich ist.

Ein als variabler Kondensator symbolisiertes kapazitives Schaltungselement KS ist mit seiner Erregerfläche EF über eine Zeilenleitung ZL an einen Impulsgenerator IG angeschlossen. bit seiner Sensorfläche SF ist das kapazitive Schaltelement KS - seine Kapazität hängt vom Betätigungszustand der Taste ab - über eine Spaltenleitung SL mit einem Meßwiderstand MW verbunden. Der Impulsgenerator IG und der Meßwiderstand MW liegen auf einem gemeinsamen Massepotential MA.

Eine parasitäre Koppelkapazität PK, die durch parallel geführte Leitungen entsteht, liegt zwischen der Zeilen- und der Spaltenleitung SL, ZL und damit parallel zum kapazitiven Schaltelement KS. Die Spalten- und Zeilenleitungen SL, ZL sind zudem jeweils über eine Serienschaltung aus einer Koppelkapazität KK mit einem Schirmflächenwiderstand SW mit dem Massepotential MA verbunden. Dabei stellt die Koppelkapazität KK die Kapazität dar, die sich jeweils zwischen einer Zeilen- oder Spaltenleitung ZL, SL mit den zweiten Schirmungsflächen, also der Grafitschicht GR bildet. Der Schirmflächenwiderstand SW ist der Wistand, der in der Grafitschicht überwunden werden muß, um auf eine Leiterbahn LB des Leiterbahnengitters zu gelangen. Der Widerstand im Leiterbahnengitter ist vernachlässigbar und deshalb nicht dargestellt.

## Patentansprüche

1. Kapazitive Schaltungskarte (F) mit mehreren auf einer isolierenden Trägerschicht (I) nebeneinander angeordneten und untereinander verbundenen kapazitiven Schaltelementen (KS), die jeweils aus einander zugeordneten, zu Kondensatorflächen (EF, SF) ausgebildeten Leiterflächen bestehen, wobei die isolierende Trägerschicht (I) an ihrer von den kapazitiven Schaltelementen (KS) abgewandten Seite eine elektrisch leitfähige **dadurch gekennzeichnet**, daß erste Schirmungsfläche aufweist, die mit einem Anschluß für ein Spannungspotential (MA) versehen ist, die erste Schirmungsfläche als Leiterbahnengitter ausgebildet ist, daß die erste Schirmungsfläche in ihren Maschenbereichen (MB) zweite, mit der ersten Schirmungsfläche in elektrischem Kontakt befindliche Schirmungsflächen aufweist und daß die erste Schirmungsfläche aus einem Leitermaterial besteht, das elektrisch leitfähiger ist als das der zweiten Schirmungsflächen.

2. Kapazitive Schaltungskarte nach Anspruch 1, **dadurch gekennzeichnet**, daß die zweiten Schirmungsflächen eine geschlossene Fläche bilden und die erste Schirmungsfläche wenigstens einseitig bedecken.

3. Kapazitive Schaltungskarte nach einem der Ansprüche 1 oder 2, **dadurch gekennzeichnet**, daß das Leitermaterial der ersten Schirmungsfläche aus Silber und das der zweiten Schirmungsfläche aus Grafit besteht.

## Claims

1. Capacitive circuit board (F) having a plurality of capacitive switching elements (KS) which are arranged alongside one another and connected to each other on an insulating carrier layer (I) and in each case comprise mutually associated conductor surfaces which are constructed to form capacitor surfaces (EF, SF), the insulating carrier layer (I) having on its side facing away from the capacitive switching elements (KS) an electrically conductive first screening surface which is provided with a connection for a voltage potential (MA), characterized in that the first screening surface is constructed as a conductor track grid, in that the first screening surface has in its mesh regions (MB) second screening surfaces, which are located in electrical contact with the first screening surface, and in that the first screening surface is composed of a conductor material which is electrically more conductive than that of the second screening surfaces.

2. Capacitive circuit board according to Claim 1, characterized in that the second screening surfaces form a closed surface and cover the first screening surface on at least one side.

3. Capacitive circuit board according to one of Claims 1 or 2, characterized in that the conductor material of the first screening surface is composed of silver and that of the second screening surface is composed of graphite.

## Revendications

1. Carte (F) capacitive de circuit comportant plusieurs éléments (KS) capacitifs de circuit, qui sont reliés entre eux, qui sont l'un à côté de l'autre sur une couche (I) isolante de support et qui sont chacun constitués de surfaces de conducteur, associées entre elles et sous forme de surfaces (EF, SF) de condensateur, la couche (I) de support isolante comportant sur sa face éloignée des éléments (KS) capacitifs de circuit une première surface électriquement conductrice de blindage, qui est munie d'une borne pour un potentiel (MA) de tension, caractérisée en ce que la première surface de blindage est formée d'une grille de pistes conductrices et la première surface de blindage comporte dans ses zones (MB) de maille, des deuxièmes surfaces de blindage, qui sont en contact électrique avec la première surface de blindage, et la première surface de blindage est en un matériau conducteur, dont la conductivité électrique est plus grande que celle des deuxièmes surfaces de blindage.

2. Carte capacitive de circuit suivant la revendication 1, caractérisée en ce que les deuxièmes surfaces de blindage forment une surface fermée et recouvrent au moins d'un côté la première surface de blindage.

3. Carte capacitive de circuit suivant l'une des revendications 1 ou 2, caractérisée en ce que le matériau conducteur de la première surface de blindage est en argent et celui de la deuxième surface de blindage en graphite.
